# EUROPEAN PATENT SPECIFICATION

(11) **EP 4 180 827 B1**
(45) Date of publication and mention of the grant of the patent: **25.02.2026**
(21) Application number: 21838073.1
(22) Date of filing: 01.07.2021
(51) Int. Cl.: G01R 31/389, G01R 31/396, G01R 31/378, H01M 10/42, G01R 31/36, G01R 31/388, G01R 31/385, G01R 29/26, G01R 31/392, H01M 10/48

(54) **METHOD FOR DETECTING STORAGE BATTERY OF VEHICLE AND BATTERY DETECTION DEVICE**
VERFAHREN ZUR ERKENNUNG EINER SPEICHERBATTERIE EINES FAHRZEUGS UND BATTERIEERKENNUNGSVORRICHTUNG
PROCÉDÉ DE DÉTECTION D'UNE BATTERIE DE STOCKAGE DE VÉHICULE ET DISPOSITIF DE DÉTECTION DE BATTERIE

(30) Priority: 10.07.2020 CN 202010663189
(43) Date of publication of application: 17.05.2023
(73) Proprietor: Autel Intelligent Technology Corp., Ltd., Shenzhen, Guangdong 518055 (CN)
(72) Inventor: QU, Songsong, Shenzhen, Guangdong 518055 (CN); FENG, Guangwen, Shenzhen, Guangdong 518055 (CN); TANG, Xinguang, Shenzhen, Guangdong 518055 (CN)
(74) Representative: Harris, Oliver John Richard
(86) International application number: PCT/CN2021/104100
(87) International publication number: WO 2022/007711

(56) References cited:
- CN-A- 101 109 789
- CN-A- 101 477 179
- CN-A- 106 324 508
- CN-A- 106 646 267
- CN-A- 108 562 858
- CN-A- 110 687 468
- CN-A- 111 077 468
- CN-A- 111 142 037
- CN-A- 111 781 521
- JP-A- 2015 135 277
- US-A1- 2001 033 169
- US-A1- 2006 170 397
- WENLIANG LI ET AL: "Optimization Method of Battery On -line Monitoring Technology", ELECTRONIC TEST, no. 9, 30 September 2017 (2017-09-30), pages 95 - 96, XP055886641, DOI: 10.16520/j.cnki.1000-8519.2017.09.045
- WANG FANG ET AL: "Experimental Analysis of Internal Resistance of Energy-Type LiFePO4 Power Batteries and Its Influencing Factors", JOURNAL OF CHONGQING UNIVERSITY OF TECHNOLOGY(NATURAL SCIENCE), vol. 31, no. 8, 31 August 2017 (2017-08-31), pages 44 - 50, XP055886644
- LI, WENLIANG ET AL.: "Optimization Method of Battery On-line Monitoring Technology", ELECTRONIC TEST, no. 9, 30 September 2017 (2017-09-30), pages 95 - 96, XP055886641
- WANG, FANG ET AL.: "Experimental Analysis of Internal Resistance of Energy-Type LiFePO4 Power Batteries and Its Influencing Factors", JOURNAL OF CHONGQING UNIVERSITY OF TECHNOLOGY(NATURAL SCIENCE), vol. 31, no. 8, 31 August 2017 (2017-08-31), pages 44 - 50, XP055886644
- FANG, HAITAO: "Research and Implementation of On-line SOC Estimation for Vehicular Lead-Acid Battery", SCIENCE-ENGINEERING (B), CHINA MASTER’S THESES FULL-TEXT DATABASE, no. 3, 15 March 2017 (2017-03-15), pages 1 - 81, XP055886648

## Description

The present application relates to the technical field of automobile electronics, and in particular to a method for detecting a storage battery of a vehicle and a battery detection device.

### BACKGROUND OF THE INVENTION

The core of the detection of a storage battery of a vehicle is to be able to quickly and accurately detect the storage battery to assess the health state of the storage battery and to assess whether the storage battery needs to be replaced. A battery detection device, such as a battery detector, is commonly used to detect the storage battery of a vehicle. Battery detection devices currently in use on the market use two methods of conductivity measurement and load test.

However, in carrying out the embodiments of the present invention, the inventors of the present invention have found that: the general conductivity measurement is tested with a load current of about 1A at 100Hz. Because the signal is weak, the signal error of millivolt level needs to be measured, and it is easy to be interfered by the environment, resulting in unstable measurement. So, this scheme generally requires the battery to be in a stable state. However, with the rapid development of vehicles, more and more high-tech functions result in more and more electric appliances and electronic units on the vehicle. Even when the vehicle is stalled, some intelligent devices are still working, which results in the storage battery being continuously in the state of power supply to the outside. Besides, there are noise signals with different frequencies. In this case, using conductivity measurement is prone to misjudge.

Load tests require large current discharges, typically exceeding 100A, and require a battery to be fully charged such that a battery in a power loss state cannot be detected.

In conclusion, it is difficult for the traditional conductivity measurement and load test to accurately test the storage battery of a vehicle, and the user satisfaction degree is not high. US 2001/033169 A1 relates to a system and method for accurate and in real time determination of factors relating to the state of health of a storage battery. JP 2015 135277 A relates to an apparatus and method for estimating a parameter of an equivalent circuit of a secondary battery.

### SUMMARY OF THE INVENTION

In view of the above problems, an embodiment of the present invention provides a method for detecting a storage battery of a vehicle and a battery detection device that overcome or at least partially solve the above problems. The invention is set out in the appended set of claims.

According to one aspect of an embodiment of the invention, a method for detecting a storage battery of a vehicle is provided, which is applied to a battery detection device, including: acquiring the noise intensity of the storage battery and battery information of the storage battery; according to the noise intensity and the battery information, selecting a battery detection scheme from among at least two preset candidate battery detection schemes, wherein the battery detection scheme comprises at least one among a discharge load value, detection frequency, duty cycle and detection time, the discharge load value and the detection frequency are each related to the noise intensity, and the duty cycle and the detection time are each related to the battery information; and detecting the storage battery according to the battery detection scheme.

In an alternative manner, the method further comprises: detecting an open circuit voltage of the storage battery; and determining a loaded capacity of the storage battery according to the open circuit voltage; wherein according to the noise intensity and the battery information, selecting one battery detection scheme from at least two preset candidate battery detection schemes comprises
selecting one battery detection scheme from at least two preset candidate battery detection schemes according to the noise intensity, the battery information, and the loaded capacity of the storage battery.

In an alternative manner, according to the noise intensity and the battery information, selecting one battery detection scheme from at least two preset candidate battery detection schemes comprises according to the noise intensity, determining at least one first candidate battery detection scheme from the preset at least two candidate battery detection schemes; according to the battery information, determining at least one second candidate battery detection scheme from the preset at least two candidate battery detection schemes; and selecting one battery detection scheme from the at least one first candidate battery detection scheme and the at least one second candidate battery detection scheme.

In an alternative manner, selecting one battery detection scheme from the at least one first candidate battery detection scheme and the at least one second candidate battery detection scheme comprises judging whether the same candidate battery detection scheme exists in the at least one first candidate battery detection scheme and the at least one second candidate detection scheme; if so, determining one battery detection scheme from the same candidate battery detection scheme; and if not, determining one battery detection scheme from the at least one second candidate battery detection scheme.

In an alternative manner, the battery information comprises a nominal capacity of the storage battery and a current capacity of the storage battery, the duty cycle and the detection time being related to the nominal capacity of the storage battery and the current capacity of the storage battery, respectively.

In an alternative manner, acquiring the noise intensity of the storage battery comprises: acquiring a voltage jump amplitude and a maximum noise voltage amplitude of the storage battery; and determining the noise intensity of the storage battery according to the voltage jump amplitude and the maximum noise voltage amplitude.

In an alternative manner, the battery information comprises an open circuit voltage and/or a temperature, wherein detecting the storage battery according to the battery detection scheme comprises: calculating an internal resistance of the storage battery according to the battery detection scheme; determining a CCA value of the storage battery according to the internal resistance of the storage battery; and detecting a health state of the storage battery according to at least one of the open circuit voltage and/or the temperature, the battery detection scheme, the internal resistance, and the CCA value.

According to one aspect of an embodiment of the present invention, there is provided an apparatus for detecting a storage battery of a vehicle, comprising: an acquisition module for acquiring the noise intensity of the storage battery and battery information of the storage battery; a selection module for according to the noise intensity and the battery information, selecting a battery detection scheme from among at least two preset candidate battery detection schemes, wherein the battery detection scheme comprises at least one among a discharge load value, detection frequency, duty cycle, and detection time, the discharge load value and the detection frequency are each related to the noise intensity, and the duty cycle and the detection time are each related to the battery information; and a first detection module for detecting the storage battery according to the battery detection scheme.

In an alternative manner, the apparatus further comprises: a second detection module for detecting an open circuit voltage of the storage battery; and a determination module for determining a loaded capacity of the storage battery according to the open circuit voltage; wherein the selection module includes: a first selection unit for selecting one battery detection scheme from at least two preset candidate battery detection schemes according to the noise intensity, the battery information, and the loaded capacity of the storage battery.

In an alternative manner, the selection module comprises: a first determination unit for according to the noise intensity, determining at least one first candidate battery detection scheme from the preset at least two candidate battery detection schemes; a second determination unit for, according to the battery information, determining at least one second candidate battery detection scheme from the preset at least two candidate battery detection schemes; and a second selection unit for selecting one battery detection scheme from the at least one first candidate battery detection scheme and the at least one second candidate battery detection scheme.

In an alternative manner, the second selection module is specifically used for: judging whether the same candidate battery detection scheme exists in at least one first candidate battery detection scheme and the at least one second candidate detection scheme; if so, determining one battery detection scheme from the same candidate battery detection scheme; and if not, determining one battery detection scheme from the at least one second candidate battery detection scheme.

In an alternative manner, the battery information comprises a nominal capacity of the storage battery and a current capacity of the storage battery, the duty cycle and the detection time being related to the nominal capacity of the storage battery and the current capacity of the storage battery, respectively.

In an alternative manner, the acquisition module comprises: an acquisition unit for acquiring a voltage jump amplitude and a maximum noise voltage amplitude of the storage battery; and a third determination unit for determining the noise intensity of the storage battery according to the voltage jump amplitude and the maximum noise voltage amplitude.

In an alternative manner, the battery information comprises open circuit voltage and/or temperature, and the first detection module comprises: a calculating unit for calculating the internal resistance of the storage battery according to the battery detection scheme; a fourth determination unit for determining a CCA value of the storage battery according to the internal resistance of the storage battery; and a detection unit for detecting a health state of the storage battery according to at least one of the open circuit voltage and/or the temperature, the battery detection scheme, the internal resistance, and the CCA value.

According to one aspect of an embodiment of the present invention, there is provided a battery detection device comprising: at least one processor; and a memory communicatively connected to at least one processor, the memory storing an instruction executable by at least one processor, wherein the instruction is executable by the at least one processor to enable the at least one processor to execute the above-mentioned method.

The beneficial effects of embodiments of the present invention are as follows. Unlike the conventional method for detecting a storage battery of a vehicle, according to an embodiment of the present invention, the following is provided: acquiring the noise intensity of the storage battery and battery information of the storage battery; according to the noise intensity and the battery information, selecting a battery detection scheme from among at least two preset candidate battery detection schemes, wherein the battery detection scheme comprises at least one among a discharge load value, detection frequency, duty cycle and detection time, the discharge load value and the detection frequency are each related to the noise intensity, and the duty cycle and the detection time are each related to the battery information; and detecting the storage battery according to the battery detection scheme. According to the embodiments of the present invention, by means of the noise intensity and the battery information, a comprehensive selection of a battery detection scheme may be used to achieve the rapid and accurate detection of the storage battery even in circumstances of noise interference and/or poor health of the storage battery.

### BRIEF DESCRIPTION OF DRAWINGS

One or more embodiments are illustrated exemplarily by the pictures in the corresponding accompanying drawings. These exemplary descriptions do not constitute a limitation on embodiments. Elements with the same reference numerals in the accompanying drawings are represented as similar elements. Unless otherwise stated, the drawings in the accompanying drawings do not constitute a limitation on the scales.
Fig. 1 is a schematic diagram of a battery detection system according to an embodiment of the present invention;
Fig. 2 is a schematic flow diagram of a method for detecting a storage battery of a vehicle according to an embodiment of the present invention;
Fig. 3 is a schematic detailed flow chart of step S10 in Fig. 2 according to an embodiment of the present invention;
Fig. 4 is a schematic detailed flow chart of step S20 in Fig. 2 according to an embodiment of the present invention;
Fig. 5 is a schematic detailed flow chart of step S30 in Fig. 2 according to an embodiment of the present invention;
Fig. 6 is a schematic flow diagram of a method for detecting a storage battery of a vehicle according to an embodiment of the present invention;
Fig. 7 is a schematic diagram of an apparatus for detecting a storage battery of a vehicle according to an embodiment of the present invention;
Fig. 8 is a schematic diagram of a structure of a hardware of a battery detection device that executes a method for detecting a storage battery of a vehicle according to an embodiment of the present invention.

### DETAILED DESCRIPTION OF THE INVENTION

In order to make the objects, technical schemes, and advantages of the present invention more apparent, a more particular description of the invention will be rendered below with reference to the embodiments and appended drawings. It is to be understood that the specific embodiments described herein are merely illustrative of the present invention and are not intended to be limiting thereof.

The method for detecting a storage battery of a vehicle provided by the present application is applied to a battery detection device that can be used to detect a battery of a storage battery of a vehicle.

In an embodiment of the present invention, the battery detection device may be an electronic device such as a battery detector, a smart phone, a palm computer, a tablet computer, a smart watch, and the like, which can detect the storage battery of a vehicle.

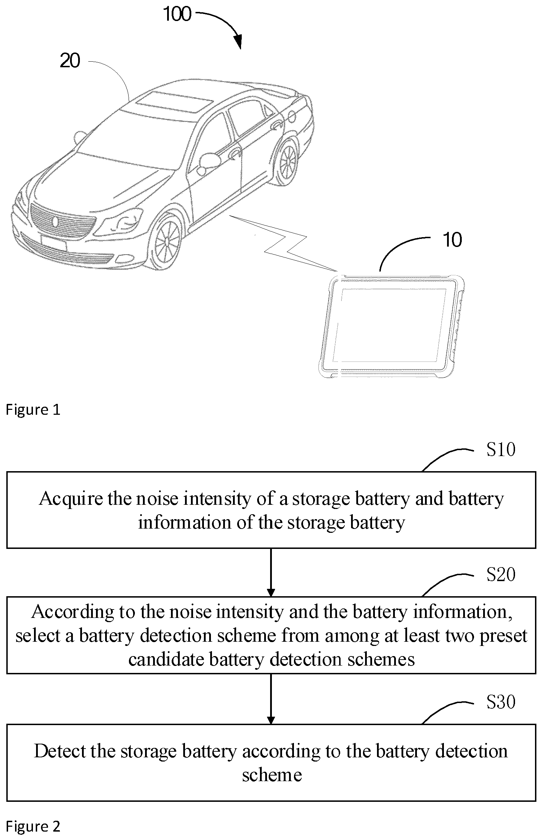

Referring to Fig. 1, Fig. 1 is a schematic diagram of a battery detection system according to an embodiment of the present invention. The battery detection system 100 includes: a battery detection device 10 and a vehicle 20 communicatively connected to the battery detection device 10.

The battery detection device 10 may be any type of a vehicle diagnostic product, including at least one electrical connector, the end of the electrical connector being used to detect the storage battery of the vehicle 20. The electrical connector includes a Kelvin connector, a low frequency circular connector, an optical fiber connector, a rectangular connector, a printed circuit connector, a radio frequency connector, etc. Preferably, the electrical connector in the embodiment of the present invention is a Kelvin connector.

In actual use, the battery detection device 10 establishes physical communication connections with various vehicle buses in the vehicle 20 through an interface module, such as a diagnostic connector and hardware communication interface, and loads appropriate or paired protocol configurations to enable data interaction with the vehicle 20, such as sending a detection instruction or receiving detection data.

The vehicle 20 may in particular be a motor vehicle of any vehicle type, such as a truck, a small vehicle 20, a bus, etc. The vehicle 20 has an electronic control system consisting of multiple electronic control units to coordinate and control the vehicle to be in accordance with an operating instruction of a driver, etc. and to monitor one or more vehicle parameters in real time to ensure the reliable and safe operation of the vehicle 20.

The communication connection between each electronic control unit in the vehicle 20 is generally by a bus. Each electronic control unit uses a specific communication protocol. The electronic control unit communicates over the corresponding vehicle 20 bus according to the communication protocol used by itself to avoid conflicts and improve the efficiency. That is, electronic control units using the same communication protocol communicate over a bus of the vehicle 20, and the bus of the vehicle 20 corresponds to a communication protocol.

A storage battery is provided on the vehicle 20 for maintaining the normal operation of the vehicle 20.

To facilitate daily service and maintenance, the vehicle 20 may also have at least one hardware communication interface, such as an OBD interface. The hardware communication interface and the vehicle 20 may be connected to one or more buses of the vehicle 20 for establishing a communication connection with an external device for implementing data interaction and the like with the electronic control unit. In an embodiment of the invention, the hardware communication interface may be used to connect to an electrical connector of the storage battery detection device 10 for data interaction.

The battery detection device 10 is used to detect the health state of the storage battery of the vehicle 20. In an embodiment of the present invention, the battery detection device 10 presets at least two candidate battery detection schemes. The battery detection device 10 first acquires the noise intensity of the storage battery and the battery information of the storage battery, and then selects one battery detection scheme from the preset at least two candidate battery detection schemes to detect the storage battery according to the noise intensity and the battery information. In the present application, by means of the noise intensity and the battery information, a comprehensive selection of a battery detection scheme may be used to achieve the rapid and accurate detection of the storage battery even in circumstances of noise interference and/or poor health of the storage battery.

### Embodiment 1

Reference is made to Fig. 2. Fig. 2 is a schematic flow diagram of a method for detecting a storage battery of a vehicle according to an embodiment of the present invention. The method includes the following steps.

Step S10, acquire the noise intensity of a storage battery and battery information of the storage battery.

In a case where a storage battery of a vehicle continuously supplies power to the outside, the environment in which the storage battery is located has various degrees of noise. When the noise intensity of the noise is small, a low load current can be used for testing; when the noise intensity of the noise is large, the low load current is used for testing, so that the detection of the storage battery is easily disturbed, thus resulting in inaccuracy. By acquiring the noise intensity of the storage battery and further performing the storage battery detection of the vehicle by adjusting the load of the battery detection device according to the noise intensity, the accuracy of the storage battery detection of the vehicle can be improved.

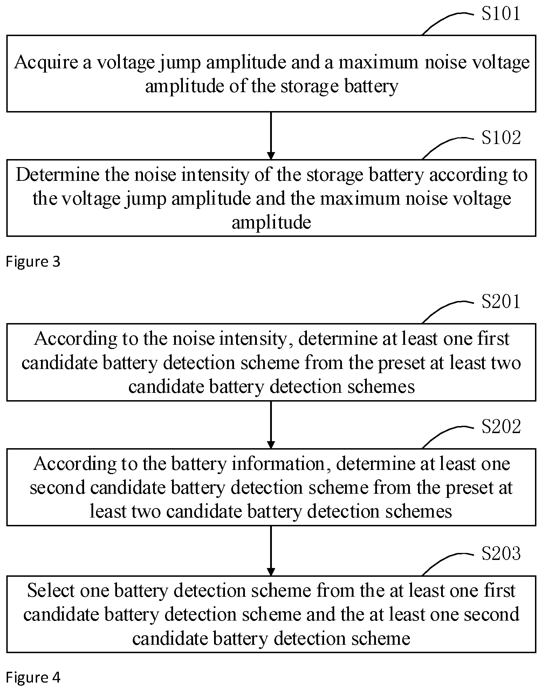

In some embodiments, the noise intensity of the storage battery may be measured according to a voltage jump amplitude and a maximum noise voltage amplitude of the storage battery. Specifically, referring to Fig. 3, step S10 includes:
step S101: acquiring a voltage jump amplitude and a maximum noise voltage amplitude of the storage battery.

Multiple voltage points are continuously tested while the battery detection device is connected to the vehicle, and subtracting a minimum value from a maximum value of the voltage point is the voltage jump amplitude. The maximum noise voltage amplitude is generally considered to be the maximum value among voltage jump amplitudes, the maximum noise voltage amplitude is a fixed value, and the maximum noise voltage amplitude is a statistical value, which can be pre-counted.

Step S102: determine the noise intensity of the storage battery according to the voltage jump amplitude and the maximum noise voltage amplitude.

The calculation formula for determining the noise intensity of the storage battery according to the voltage jump amplitude and the maximum noise voltage amplitude is as follows:
The noise intensity of the storage battery = the voltage jump amplitude/ the maximum noise voltage amplitude

It needs to be noted that, in some embodiments, the noise intensity of the storage battery is represented by 1-100; when the calculated noise intensity is greater than 100, the noise intensity of the storage battery may be directly defined as 100; when the calculated noise intensity is smaller than 1, the noise intensity of the storage battery may be directly defined as 1.

For the battery information, the battery information includes the nominal capacity of the storage battery, a current capacity of the storage battery, an open circuit voltage, and a temperature. The nominal capacity of the storage battery and the current capacity of the storage battery are used to select the battery detection scheme. The open circuit voltage and/or the temperature are used to detect the health state of the storage battery.

The nominal capacity of the storage battery is used for measuring the amount of the stored electric quantity of the storage battery, and the nominal capacity of the storage battery is the capacity of the storage battery measured from full electricity to no electricity, and the unit is mAh or Ah. In some embodiments, the battery detection device acquires the vehicle identification information of the vehicle input by a user, and determines a nominal capacity of the storage battery corresponding to the vehicle according to the vehicle identification information.

The current capacity of the storage battery is obtainable by a load test. The load test is generally to apply a load on two ends of a battery, so that the storage battery generates a discharge current of about 10A-100A for a certain time (1ms-1s); when the load is applied, the change of voltage drop of the storage battery is tested such that the voltage drop amplitude is obtained. When a large load is applied to different storage battery capacities, there is a certain linear relationship in the amplitude of the voltage drop. The current capacity value of the storage battery is finally estimated through the relationship between the drop amplitude of the storage battery and the storage battery capacity under different voltages. The unit of the storage battery capacity is mAh or Ah.

Step S20, according to the noise intensity and the battery information, select a battery detection scheme from among at least two preset candidate battery detection schemes.

The battery detection scheme comprises at least one of a discharge load value, a detection frequency, a duty cycle, and a detection time. The discharge load value and the detection frequency are respectively related to the noise intensity, and the duty cycle and the detection time are respectively related to the battery information.

It could be understood that if the noise intensity is large, a battery detection scheme with a small discharge load value and a small detection frequency is chosen.

The duty cycle and the detection time are related to the nominal capacity of the storage battery and the current capacity of the storage battery, respectively. It could be understood that where the nominal capacity of the storage battery is large, a battery detection scheme with a large duty cycle may be selected. When the current capacity of the storage battery is small, the battery detection scheme having a long detection time is selected.

For example, the preset at least two candidate battery detection schemes include scheme one, scheme two, scheme three, scheme four, and scheme five.

Scheme one comprises a discharge load value of 10 Ohm, a detection frequency of 100 Hz, a duty cycle of 50%, and a detection time of 1-15 seconds.

Scheme two comprises a discharge load value of 1 Ohm, a detection frequency of 2 Hz, a duty cycle of 5%, and a detection time of 1-30 seconds.

Scheme three comprises a discharge load value of 0.5 Ohm, a detection frequency of 1 Hz, a duty cycle of 0.5%, and a detection time of 1-30 seconds.

Scheme four comprises a discharge load value of 0.3 Ohm, a detection frequency of 1 Hz, a duty cycle of 0.2%, and a detection time of 1-10 seconds.

Scheme five comprises a discharge load value of 0.2 Ohm, a detection frequency of 1 Hz, a duty cycle of 0.1%, and a detection time of 1-5 seconds.

One battery detection scheme may be comprehensively selected according to the noise intensity, the nominal capacity of the storage battery, and the current capacity of the storage battery.

It needs to be noted that the preset at least two candidate detection schemes are not limited to the above-mentioned scheme one, scheme two, scheme three, scheme four, and scheme five, and may be other schemes. The candidate detection scheme may be pre-set, namely, the value of the detection parameter in each scheme is fixed; alternatively, the candidate detection scheme may be dynamically obtained according to the detected noise intensity and battery information.

The value of each parameter in the candidate detection scheme may be in the following range, and the candidate detection scheme may only comprise a combination of parameters in each value range. The embodiment of the present application does not define the combination relationship between the parameter value and the parameter.

For example, the range of the discharge load value may be [0.2 Ohm, 10 Ohm]; the range of the detection frequency may be [0, 1 KHz]; the range of the duty cycle may be [0.1, 50%]; the detection time may also be understood to be a detection duration, having a range of [0.5s, 30s].

With reference to Fig. 4, Fig. 4 is a schematic detailed flow diagram of step S20 in Fig. 2. Step S20 comprises:
step S201: according to the noise intensity, determine at least one first candidate battery detection scheme from the preset at least two candidate battery detection schemes; and
step S202: according to the battery information, determine at least one second candidate battery detection scheme from the preset at least two candidate battery detection schemes.

As previously described, the battery information includes a nominal capacity and a current capacity, and the battery detection scheme includes a duty cycle and a detection time, the duty cycle and the detection time being related to the nominal capacity of the storage battery and the current capacity of the storage battery, respectively. Then, in some embodiments, the step S202 specifically comprises: determining at least one first primary battery detection scheme from the preset at least two candidate battery detection schemes according to the nominal capacity; determining at least one second primary battery detection scheme from the preset at least two candidate battery detection schemes according to the current capacity; and judging whether the same candidate battery detection scheme exists in the at least one first primary battery detection scheme and the at least one second primary battery detection scheme; wherein if so, the same candidate battery detection scheme is determined as the second candidate battery detection scheme; if not, the second primary battery detection scheme is determined as the second candidate battery detection scheme.

Step S203: select one battery detection scheme from the at least one first candidate battery detection scheme and the at least one second candidate battery detection scheme.

In some embodiments, step S203 specifically includes: judging whether the same candidate battery detection scheme exists in the at least one first candidate battery detection scheme and the at least one second candidate battery detection scheme. If so, one battery detection scheme is determined from the same candidate battery detection scheme; if not, one battery detection scheme is determined from the at least one second candidate battery detection scheme.

In some embodiments, if there are two or more of the same candidate battery detection schemes, determining one battery detection method from the same candidate battery detection schemes comprises determining a battery detection scheme with a small discharge load value as the final battery detection scheme.

In some embodiments, determining one battery detection scheme from the at least one second candidate battery detection scheme comprises determining a battery detection scheme with a small duty cycle and/or a long detection time as the final battery detection scheme.

It needs to be noted that in some embodiments, when there are multiple samecandidate battery detection schemes, two or more schemes may be selected from the same candidate battery detection schemes to respectively detect the storage battery of the vehicle, and the detection results of each detection are integrated, for example, an average value being obtained to obtain the final detection result. Or multiple candidate battery detection schemes may be used to respectively detect the storage battery of the vehicle without selecting a scheme, and then the detection results are averaged.

In order to make the readers better understand the inventive concept of the present invention, a method for selecting a battery detection scheme according to embodiment 1 of the present invention will now be illustrated.

Taking the candidate battery detection schemes including the above-mentioned scheme one, scheme two, scheme three, scheme four, and scheme five as an example, a method for detecting a storage battery by selecting a battery detection scheme from the candidate battery detection schemes according to noise intensity and battery information is described.

If the acquired noise intensity is small, correspondingly the range of the schemes that can be selected is large, namely, when the noise intensity is small, the effect on the detection results of each scheme by the noise is small; if the acquired noise intensity is high, a scheme with a low discharge load value is correspondingly selected so as to discharge the storage battery with a large current and reduce the influence of the noise intensity on the detection result.

For example, it is set that
when the noise intensity is 1-5, the first candidate battery detection schemes include scheme one, scheme two, scheme three, scheme four, and scheme five;
when the noise intensity is 6-20, the first candidate battery detection schemes include scheme two, scheme three, scheme four, and scheme five;
when the noise intensity is 21-40, the first candidate battery detection schemes include scheme three, scheme four, and scheme five;
when the noise intensity is 41-70, the first candidate battery detection schemes include scheme three, scheme four, and scheme five;
and when the noise intensity is 71-100, the first candidate battery detection schemes include scheme three, scheme four, and scheme five.

If the acquired nominal capacity is large, correspondingly the range of the schemes that can be selected is large, namely, when the nominal capacity is large, the effect on the detection results of each scheme by the duty cycle is small, and selecting a slightly large duty cycle can improve the discharge efficiency of the storage battery; if the acquired nominal capacity is small, a scheme with a small duty cycle is correspondingly selected so as to improve the discharge condition of the storage battery and reduce heat generation.

For example, it is set that
when the nominal capacity is 30-50 Ah, the first primary battery detection scheme includes scheme two, scheme three, scheme four, and scheme five;
when the nominal capacity is 50-200 Ah, the first primary battery detection scheme includes scheme one, scheme two, scheme three, scheme four, and scheme five.

If the acquired current capacity is small, a candidate battery detection scheme with a long detection time can be selected correspondingly so as to improve the detection accuracy; if the acquired current capacity is large, a candidate battery detection scheme with a short detection time can be selected correspondingly, thereby saving resources.

For example, it is set that
when the current capacity is less than 50% of the nominal capacity, the detection time should be greater than or equal to 15 seconds, and the second primary battery detection scheme comprises scheme one, scheme two, and scheme three;
when the current capacity is greater than or equal to 50% of the nominal capacity, the detection time should be less than 15 seconds, and the second primary battery detection scheme comprises scheme four and scheme five.

For example, when the acquired noise intensity is 4, the nominal capacity is 80 Ah, and the current capacity is 60% of the nominal capacity, then the first candidate battery detection scheme is scheme one, scheme two, scheme three, scheme four, and scheme five, the first primary battery detection scheme is scheme one, scheme two, scheme three, scheme four, and scheme five, and the second primary battery detection scheme is scheme four and scheme five; if it is judged that the first primary battery detection scheme and the second primary battery detection scheme have the same candidate battery detection scheme, scheme four and scheme five, then the second candidate battery detection scheme is scheme four and scheme five, and if it is judged that the first candidate battery detection scheme and the second candidate battery detection scheme have the same candidate battery detection scheme, scheme four and scheme five, then a battery detection scheme with a small discharge load value can be preferentially selected, and then scheme five is determined as the final battery detection scheme; alternatively, the storage battery is detected by scheme four and scheme five respectively, and the detection results of the two detections are integrated as the final detection result.

For example, when the acquired noise intensity is 60, the nominal capacity is 40 Ah, and the current capacity is 30% of the nominal capacity, then the first candidate battery detection scheme is scheme three, scheme four, and scheme five, the first primary battery detection scheme is scheme two, scheme three, scheme four, and scheme five, and the second primary battery detection scheme is scheme one, scheme two, and scheme three; if it is judged that the first primary battery detection scheme and the second primary battery detection scheme have the same candidate battery detection scheme, scheme two and scheme three, then the second candidate battery detection scheme is scheme two and scheme three, and if it is judged that the first candidate battery detection scheme and the second candidate battery detection scheme have the same candidate battery detection scheme, scheme three, then scheme three is determined to be the final battery detection scheme.

Step S30, detect the storage battery according to the battery detection scheme.

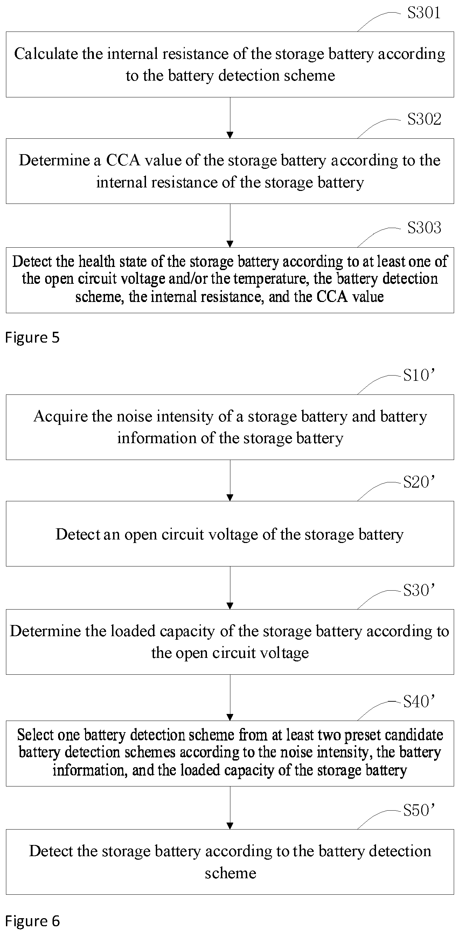

With reference to Fig. 5, Fig. 5 is a schematic detailed flow diagram of step S30 in Fig. 2. Step S30 comprises:
step S301: calculate the internal resistance of the storage battery according to the battery detection scheme.

The internal resistance of the storage battery can be calculated by measuring the difference between the storage battery voltage when the storage battery is loaded and the storage battery voltage when the storage battery is unloaded. According to the formula Rb= (V - Vr) / I, Rb is the internal resistance of the storage battery, V is the voltage of the storage battery under no load, Vr is the voltage of the storage battery tested under load, and I is the current tested under load.

Step S302: determine a CCA value of the storage battery according to the internal resistance of the storage battery.

There is a certain correspondence relationship between the CCA value of the storage battery and the internal resistance of the storage battery, and the CCA value of the storage battery can be determined from the internal resistance of the storage battery. In some embodiments, CCA = scale factor/Rb + standard value. The scale factor is a fixed value, Rb is the internal resistance of the storage battery, and the standard value is a fixed value.

Step S303: detect the health state of the storage battery according to at least one of the open circuit voltage and/or the temperature, the battery detection scheme, the internal resistance, and the CCA value.

For example, the health state of the storage battery may be detected according to the CCA value. The storage battery is considered to be healthy when the CCA value is greater than 80% of the nominal CCA, the storage battery is considered to be in a critical uncertain state when the CCA value is between 73% and 80% of the nominal CCA, and the storage battery is considered to be damaged when the CCA value is less than 73% of the nominal CCA.

As another example, the health state of the storage battery may be detected according to the CCA value and the temperature. The CCA value measured at 10° is 400, then, plus the effect of the temperature, the final CCA value at 10° will be multiplied by the scale parameter 1.1, i.e., the final CCA value will be 400*1.1=440. Further, the storage battery is considered to be healthy when the final CCA value is greater than 80% of the nominal CCA, the storage battery is considered to be in a critical uncertain state when the final CCA value is between 73% and 80% of the nominal CCA, and the storage battery is considered to be damaged when the final CCA value is less than 73% of the nominal CCA.

It needs to be noted that, in some embodiments, when the detection result is a critical uncertain state or the detection result of the health state of the storage battery is not recognized by the user, the health state of the storage battery may be detected again according to the detection method provided by an embodiment of the present invention or the CCA value of the storage battery is input by the user to detect the storage battery again.

Specifically, the method for detecting a storage battery of a vehicle includes: acquiring a noise intensity of the storage battery and battery information of the storage battery; acquiring a CCA value of the storage battery, wherein the CCA value of the storage battery is detected in a previous detection cycle; determining at least one first candidate battery detection scheme from the preset at least two candidate battery detection schemes according to the noise intensity; determining at least one second candidate battery detection scheme from the preset at least two candidate battery detection schemes according to the battery information; determining at least one fourth candidate battery detection scheme from the preset at least two candidate battery detection schemes according to the CCA value of the storage battery; and selecting one battery detection scheme from the at least one first candidate battery detection scheme, the at least one second candidate battery detection scheme, and the at least one fourth candidate battery detection scheme.

Selecting one battery detection scheme from the at least one first candidate battery detection scheme, the at least one second candidate battery detection scheme, and the at least one fourth candidate battery detection scheme specifically includes judging whether the same candidate battery detection scheme exists in the at least one first candidate battery detection scheme, the at least one second candidate battery detection scheme, and the at least one fourth candidate battery detection scheme. If so, one battery detection scheme is determined from the same candidate battery detection scheme; if not, one battery detection scheme is determined from the at least one fourth candidate battery detection scheme.

If the acquired CCA value of the storage battery is large, it indicates that the health state of the storage battery is good, and correspondingly the range of schemes that can be selected is large; if the acquired CCA value of the storage battery is small, the scheme with a large discharge load value is selected correspondingly, so as to ensure the accuracy of the detection.

For example, it is set that
the CCA value of the storage battery is greater than or equal to 80% of the nominal CCA, and the fourth candidate battery detection scheme comprises scheme one, scheme two, scheme three, scheme four, and scheme five;
the CCA value of the storage battery is less than 80% of the nominal CCA, and the fourth candidate battery detection scheme comprises scheme one, scheme two, scheme three, and scheme four.

For example, when the acquired noise intensity is 4, the nominal capacity is 80 Ah, the current capacity is 60% of the nominal capacity, and the CCA value of the storage battery is 60% of the nominal CCA, then the first candidate battery detection scheme is scheme one, scheme two, scheme three, scheme four, and scheme five, the first primary battery detection scheme is scheme one, scheme two, scheme three, scheme four, and scheme five, and the second primary battery detection scheme is scheme four and scheme five; if it is judged that the first primary battery detection scheme and the second primary battery detection scheme have the same candidate battery detection scheme, scheme four and scheme five, then the second candidate battery detection scheme is scheme four and scheme five, and the fourth candidate battery detection scheme comprises scheme one, scheme two, scheme three, and scheme four; then the first candidate battery detection scheme, the second candidate battery detection scheme, and the fourth candidate battery detection scheme have the same candidate battery detection scheme, scheme four, and then scheme four is determined as the final battery detection scheme.

For example, when the acquired noise intensity is 4, the nominal capacity is 80 Ah, the current capacity is 80% of the nominal capacity, and the CCA value of the storage battery is 90% of the nominal CCA, then the first candidate battery detection scheme is scheme one, scheme two, scheme three, scheme four, and scheme five, the first primary battery detection scheme is scheme one, scheme two, scheme three, scheme four, and scheme five, and the second primary battery detection scheme is scheme four and scheme five; if it is judged that the first primary battery detection scheme and the second primary battery detection scheme have the same candidate battery detection scheme, scheme four and scheme five, then the second candidate battery detection scheme is scheme four and scheme five, and the fourth candidate battery detection scheme comprises scheme one, scheme two, scheme three, scheme four, and scheme five; then the first candidate battery detection scheme, the second candidate battery detection scheme, and the fourth candidate battery detection scheme have the same candidate battery detection scheme, scheme four and scheme five, and a battery detection scheme with a small discharge load value can be preferentially selected, and then scheme five is determined as the final battery detection scheme; alternatively, the storage battery is detected by scheme four and scheme five respectively, and the detection results of the two detections are integrated as the final detection result.

It needs to be noted that the last detection result may be taken as the final detection result, or, if the battery detection device has a memory function, the most recent two or more detection results and the average of the most recent two or more detection results may be output simultaneously.

Of course, if one of the detection results deviates greatly from the detection results of the other times, the battery detection device automatically deletes the detection result that deviates greatly, or the user may manually delete the detection result that deviates greatly.

It needs to be noted that in some embodiments, the method for detecting a storage battery of a vehicle further includes displaying the health state of the storage battery. The battery detection device displays not only the health state of the storage battery, but also the CCA value, open circuit voltage, internal resistance value, temperature, and the like of the storage battery.

In an embodiment of the present invention, the noise intensity of the storage battery and the battery information of the storage battery are acquired; one battery detection scheme is selected from at least two preset candidate battery detection schemes according to the noise intensity and the battery information; wherein the battery detection scheme comprises at least one of a discharge load value, a detection frequency, a duty cycle, and a detection time, the discharge load value and the detection frequency being respectively related to the noise intensity, and the duty cycle and the detection time being respectively related to the battery information; according to the battery detection scheme, the storage battery is detected such that rapid and accurate detection of the storage battery can also be achieved in the case of noise interference and/or poor health state of the storage battery.

### Embodiment 2

Reference is made to Fig. 6. Fig. 6 is a schematic flow diagram of another method for detecting a storage battery of a vehicle according to an embodiment of the present invention. The method includes the following steps.

Step S10', acquire the noise intensity of a storage battery and battery information of the storage battery.

Step S20', detect an open circuit voltage of the storage battery.

The open circuit voltage of the storage battery is the voltage of the storage battery without a load.

Step S30': determine the loaded capacity of the storage battery according to the open circuit voltage.

For example, in some embodiments, when the open circuit voltage is greater than or equal to 12.5 volts, the storage battery is considered to have a high loaded capacity, and when the open circuit voltage is less than 12.5 volts, the storage battery is considered to have a low loaded capacity.

Step S40', select one battery detection scheme from at least two preset candidate battery detection schemes according to the noise intensity, the battery information, and the loaded capacity of the storage battery.

The battery detection scheme comprises at least one of a discharge load value, a detection frequency, a duty cycle, and a detection time. The discharge load value and the detection frequency are respectively related to the noise intensity, and the duty cycle and the detection time are respectively related to the battery information.

Selecting one battery detection scheme from at least two preset candidate battery detection schemes according to the noise intensity, the battery information, and the loaded capacity of the storage battery specifically includes: determining at least one first candidate battery detection scheme from the preset at least two candidate battery detection schemes according to the noise intensity; determining at least one second candidate battery detection scheme from the preset at least two candidate battery detection schemes according to the battery information; determining at least one third candidate battery detection scheme from the preset at least two candidate battery detection schemes according to the loaded capacity of the storage battery; and selecting one battery detection scheme from the at least one first candidate battery detection scheme, the at least one second candidate battery detection scheme, and the at least one third candidate battery detection scheme.

Selecting one battery detection scheme from the at least one first candidate battery detection scheme, the at least one second candidate battery detection scheme, and the at least one third candidate battery detection scheme specifically includes judging whether the same candidate battery detection scheme exists in the at least one first candidate battery detection scheme, the at least one second candidate battery detection scheme, and the at least one third candidate battery detection scheme. If so, one battery detection scheme is determined from the same candidate battery detection scheme; if not, one battery detection scheme is determined from the at least one third candidate battery detection scheme.

In order to make the readers better understand the inventive concept of the present invention, a method for selecting a battery detection scheme according to embodiment 2 of the present invention will now be illustrated.

With regard to the above-mentioned scheme one, scheme two, scheme three, scheme four, and scheme five,
for example, it is set that
when the noise intensity is 1-5, the first candidate battery detection schemes include scheme one, scheme two, scheme three, scheme four, and scheme five;
when the noise intensity is 6-20, the first candidate battery detection schemes include scheme two, scheme three, scheme four, and scheme five;
when the noise intensity is 21-40, the first candidate battery detection schemes include scheme three, scheme four, and scheme five;
when the noise intensity is 41-70, the first candidate battery detection schemes include scheme three, scheme four, and scheme five;
and when the noise intensity is 71-100, the first candidate battery detection schemes include scheme three, scheme four, and scheme five.

For example, it is set that
when the nominal capacity is 30-50 Ah, the first primary battery detection scheme includes scheme two, scheme three, scheme four, and scheme five;
when the nominal capacity is 50-200 Ah, the first primary battery detection scheme includes scheme one, scheme two, scheme three, scheme four, and scheme five.

For example, it is set that
when the current capacity is less than 50% of the nominal capacity, the detection time should be greater than or equal to 15 seconds, and the second primary battery detection scheme comprises scheme one, scheme two, and scheme three;
when the current capacity is greater than or equal to 50% of the nominal capacity, the detection time should be less than 15 seconds, and the second primary battery detection scheme comprises scheme four and scheme five.

If the acquired open circuit voltage is large, it indicates that the loaded capacity of the storage battery is strong, and correspondingly the range of schemes that can be selected is wide, namely, when the loaded capacity is strong, the effect on detection results of each scheme by the loaded capacity is small; if the acquired open circuit voltage is small, the scheme with large discharge load value is selected correspondingly to ensure the accuracy of the detection.

For example, it is set that
if the open circuit voltage is greater than or equal to 12.5 volts, then the storage battery is considered to have a strong loaded capacity, and the third candidate battery detection scheme comprises scheme one, scheme two, scheme three, scheme four, and scheme five;
if the open circuit voltage is less than 12.5 volts, the loaded capacity of the storage battery is considered to be weak, and the third candidate battery detection scheme includes scheme one, scheme two, scheme three, and scheme four.

For example, when the acquired noise intensity is 4, the nominal capacity is 80 Ah, the current capacity is 60% of the nominal capacity, and the open circuit voltage is 11, then the first candidate battery detection scheme is scheme one, scheme two, scheme three, scheme four, and scheme five, the first primary battery detection scheme is scheme one, scheme two, scheme three, scheme four, and scheme five, and the second primary battery detection scheme is scheme four and scheme five; if it is judged that the first primary battery detection scheme and the second primary battery detection scheme have the same candidate battery detection scheme, scheme four and scheme five, then the second candidate battery detection scheme is scheme four and scheme five, and the third candidate battery detection scheme comprises scheme one, scheme two, scheme three, and scheme four; then the first candidate battery detection scheme, the second candidate battery detection scheme, and the third candidate battery detection scheme have the same candidate battery detection scheme, scheme four, and then scheme four is determined as the final battery detection scheme.

For example, when the acquired noise intensity is 4, the nominal capacity is 80 Ah, the current capacity is 80% of the nominal capacity, and the open circuit voltage is 13, then the first candidate battery detection scheme is scheme one, scheme two, scheme three, scheme four, and scheme five, the first primary battery detection scheme is scheme one, scheme two, scheme three, scheme four, and scheme five, and the second primary battery detection scheme is scheme four and scheme five; if it is judged that the first primary battery detection scheme and the second primary battery detection scheme have the same candidate battery detection scheme, scheme four and scheme five, then the second candidate battery detection scheme is scheme four and scheme five, and the third candidate battery detection scheme comprises scheme one, scheme two, scheme three, scheme four, and scheme five; then the first candidate battery detection scheme, the second candidate battery detection scheme, and the third candidate battery detection scheme have the same candidate battery detection scheme, scheme four and scheme five, and a battery detection scheme with a small discharge load value can be preferentially selected, and then scheme five is determined as the final battery detection scheme; alternatively, the storage battery is detected by scheme four and scheme five respectively, and the detection results of the two detections are integrated as the final detection result.

In some embodiments, the loaded capacity of the storage battery is also related to a load voltage drop. When the loaded voltage drop is large, the battery detection scheme needs to be adjusted to a scheme that includes a large discharge load value.

In practical applications, if the open circuit voltage of the storage battery is greater than or equal to 12.5 volts, 1 A load current is started for 1-10 seconds and the loaded voltage drop condition is collected and recorded. If the loaded voltage drop is small, 10 A load current is started for 10 milliseconds to 1 second and the loaded voltage drop condition is collected and recorded. If the open circuit voltage of the storage battery is less than 12.5 volts, a 1 A load current is started for 1 second to 10 seconds and the loaded voltage drop condition is collected and recorded. Further, the battery detection scheme is adjusted according to the loaded voltage.

Step S50', detect the storage battery according to the battery detection scheme.

It could be understood that in some embodiments, after one detection cycle is completed by the detection method of embodiment 2, the CCA of the storage battery is acquired, and the storage battery can be detected again according to the CCA value of the storage battery, namely, the storage battery is detected according to the noise intensity, the battery information, the loaded capacity of the storage battery, and the CCA of the storage battery. The specific detection method and detection process can be referred to embodiment 1, and will not be described in detail herein.

In the embodiment of the present invention, the noise intensity of the storage battery and the battery information of the storage battery are acquired; the open circuit voltage of the storage battery is detected; the loaded capacity of the storage battery is determined from the open circuit voltage; one battery detection scheme is selected from at least two preset candidate battery detection schemes according to the noise intensity, the battery information, and the loaded capacity of the storage battery; according to the battery detection scheme, the storage battery is detected. The accuracy of detecting the storage battery can be further improved.

### Embodiment 3

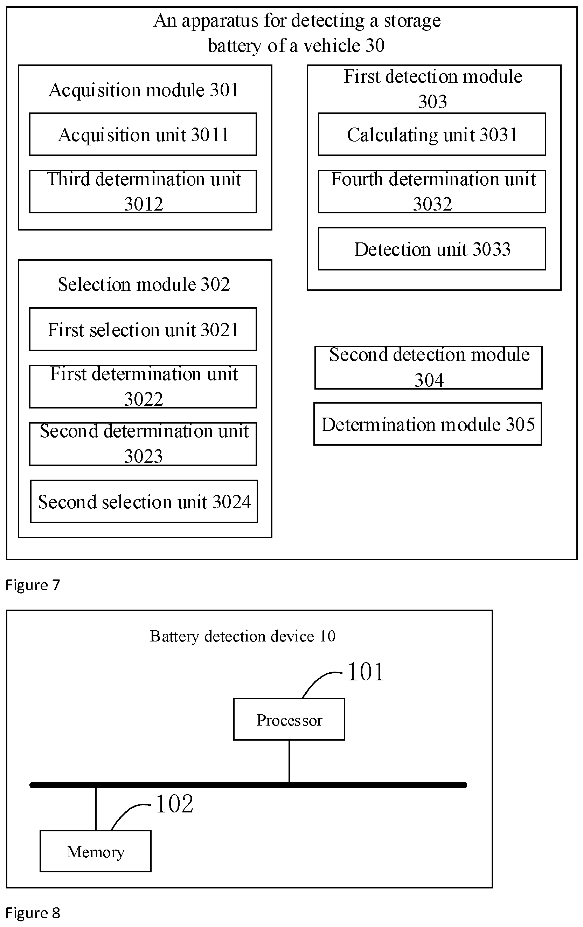

With reference to Fig. 7, Fig. 7 is a schematic diagram of an apparatus for detecting a storage battery of a vehicle according to an embodiment of the present invention. The apparatus 30 includes an acquisition module 301, a selection module 302, and a first detection module 303. The acquisition module 301 is used for acquiring the noise intensity of the storage battery and battery information of the storage battery; the selection module 302 is used for, according to the noise intensity and the battery information, selecting a battery detection scheme from among at least two preset candidate battery detection schemes, wherein the battery detection scheme comprises at least one among a discharge load value, detection frequency, duty cycle, and detection time, the discharge load value and the detection frequency are each related to the noise intensity, and the duty cycle and the detection time are each related to the battery information; the first detection module 303 is used for detecting the storage battery according to the battery detection scheme.

In some embodiments, the apparatus 30 also includes a second detection module 304 and a determination module 305. The second detection module 304 is used for detecting an open circuit voltage of the storage battery; the determination module 305 is used for determining the loaded capacity of the storage battery from the open circuit voltage; the selection module 302 comprises: a first selection unit 3021 for selecting one battery detection scheme from at least two preset candidate battery detection schemes according to the noise intensity, the battery information, and the loaded capacity of the storage battery.

In some embodiments, the selection module 302 further comprises: a first determination unit 3022, a second determination unit 3023, and a second selection unit 3024. The first determination unit 3022 is used for determining at least one first candidate battery detection scheme from the preset at least two candidate battery detection schemes according to the noise intensity; the second determination unit 3023 is used for determining at least one second candidate battery detection scheme from the preset at least two candidate battery detection schemes according to the battery information; the second selection unit 3024 is used for selecting one battery detection scheme from the at least one first candidate battery detection scheme and the at least one second candidate battery detection scheme.

In some embodiments, the second selection unit 3024 is specifically for: judging whether the same candidate battery detection scheme exists in the at least one first candidate battery detection scheme and the at least one second candidate battery detection scheme; if so, one battery detection scheme is determined from the same candidate battery detection schemes; if not, one battery detection scheme is determined from the at least one second candidate battery detection scheme.

In some embodiments, the battery information comprises the nominal capacity of the storage battery and the current capacity of the storage battery, the duty cycle and the detection time being related to the nominal capacity of the storage battery and the current capacity of the storage battery, respectively.

In some embodiments, the acquisition module 301 includes: an acquisition unit 3011 and a third determination unit 3012. The acquisition unit 3011 is used for acquiring a voltage jump amplitude and a maximum noise voltage amplitude of the storage battery; the third determination unit 3012 is used for determining the noise intensity of the storage battery according to the voltage jump amplitude and the maximum noise voltage amplitude.

In some embodiments, the battery information comprises open circuit voltage and/or temperature, and the first detection module 303 comprises: a calculating unit 3031, a fourth determination unit 3032, and a detection unit 3033. The calculating unit 3031 is used for calculating the internal resistance of the storage battery according to the battery detection scheme; the fourth determination unit 3032 is used for determining a CCA value of the storage battery according to the internal resistance of the storage battery; the detection unit 3033 is used for detecting the health state of the storage battery according to at least one of the open circuit voltage and/or the temperature, the battery detection scheme, the internal resistance, and the CCA value.

In an embodiment of the present invention, the noise intensity of the storage battery and the battery information of the storage battery are acquired by the acquisition module; one battery detection scheme is selected from at least two preset candidate battery detection schemes according to the noise intensity and the battery information by the selection module; wherein the battery detection scheme comprises at least one of a discharge load value, a detection frequency, a duty cycle, and a detection time, the discharge load value and the detection frequency being respectively related to the noise intensity, and the duty cycle and the detection time being respectively related to the battery information; according to the battery detection scheme, the storage battery is detected by the first detection module such that rapid and accurate detection of the storage battery can also be achieved in the case of noise interference and/or poor health state of the storage battery.

### Embodiment 4

Reference is made to Fig. 8. Fig. 8 is a schematic diagram of a structure of a hardware of a battery detection device that executes a method for detecting a storage battery of a vehicle according to an embodiment of the present invention. The battery detection device 10 includes: one or more processors 101 and memory 102. In Fig. 8, one memory is taken as an example.

The processor 101 and the memory 102 may be connected via a bus or in other ways, the connection via a bus being exemplified in Fig. 8.

The memory 102 is a non-volatile computer-readable storage medium that can be used to store a non-volatile software program, a non-volatile computer-executable program, and a module, such as program instructions/modules (e.g. the respective modules shown in Fig. 7) corresponding to a method for detecting a storage battery of a vehicle in an embodiment of the present invention. The processor 101 executes various functional applications and data processing of the apparatus for detecting a storage battery of a vehicle, i.e., the method for detecting a storage battery of a vehicle in the above-described method embodiment is implemented, by running a non-volatile software program, an instruction, and a module stored in the memory 102.

The memory 102 can include a storage program area and a storage data area, wherein the storage program area can store an operating system and an application program required by at least one function; the storage data area may store data and the like created according to the use of the apparatus for detecting the storage battery of the vehicle. In addition, the memory 102 may include high-speed random-access memory and may also include non-volatile memory, such as at least one magnetic disk storage device, flash memory device, or other non-volatile solid-state storage devices. In some embodiments, the memory 102 may optionally include memory remotely provided with respect to the processor 101. The remote the memory may be connected to the apparatus for detecting the storage battery of the vehicle via a network. Instances of the above-mentioned network include, but are not limited to, the Internet, intranets, local area networks, mobile communication networks, and combinations thereof.

The one or more modules are stored in the memory 102 and, when executed by the one or more processors 101, execute the method for detecting a storage battery of a vehicle in any of the method embodiments described above.

The above-mentioned product can execute the method provided by the embodiment of the present invention, and has corresponding functional modules and beneficial effects for executing the method. Technical details not described in detail in the embodiments can be referred to the method provided by the embodiments of the present invention.

An embodiment of the present invention provides a non-volatile computer-readable storage medium storing a computer-executable instructions. The computer-executable instruction is executed by the electronic device with regard to the method for detecting a storage battery of a vehicle of any of the method embodiments.

An embodiment of the present invention provides a computer program product comprising a computer program stored on a non-volatile computer-readable storage medium. The computer program comprises a program instruction that, when executed by a computer, causes the computer to execute the method for detecting a storage battery of a vehicle of any of the method embodiments.

From the above description of the implementation modes, those skilled in the art can clearly understand that each implementation mode can be realized by means of software plus a general hardware platform, and of course, by means of hardware. It could be understood by those of ordinary skills in the art that implementing all or part of the flow of the methods of the embodiments described above can be accomplished by a computer program instructing the associated hardware. The program can be stored on a computer-readable storage medium, and when executed, can include the flow of the embodiments of the methods described above. The storage medium may be a magnetic disk, an optical disk, a Read-Only Memory (ROM) or a Random Access Memory (RAM), etc.

Finally, it should be noted that the above embodiments are merely illustrative of the technical schemes of the present invention, rather than limiting it; combinations of technical features in the above embodiments or in different embodiments are also possible under the concept of the invention, the steps can be implemented in any order, and there are many other variations of different aspects of the invention described above, which are not provided in detail for the sake of brevity; although the present invention has been described in detail with reference to the foregoing embodiments, those skilled in the art should appreciate that the technical schemes disclosed in the above-mentioned embodiments can still be amended; such modifications or substitutions do not make the essence of the corresponding technical scheme depart from the scope of the technical schemes of the embodiments of the invention.

## Claims

1. A method for detecting a storage battery of a vehicle (20) to assess a health state of the storage battery, applied to a battery detection device (10), **characterized by** comprising:
acquiring noise intensity of a storage battery and battery information of the storage battery;
selecting one battery detection scheme from at least two preset candidate battery detection schemes according to the noise intensity and the battery information; wherein the battery detection scheme comprises at least one of a discharge load value, a detection frequency, a duty cycle, and a detection time, wherein the discharge load value and the detection frequency are respectively related to the noise intensity, and the duty cycle and the detection time are respectively related to the battery information;
and detecting the storage battery according to the battery detection scheme.

2. The method according to claim 1, **characterized by** further comprising:
detecting an open circuit voltage of the storage battery;
and determining a loaded capacity of the storage battery according to the open circuit voltage;
wherein according to the noise intensity and the battery information, selecting one battery detection scheme from at least two preset candidate battery detection schemes comprises
selecting one battery detection scheme from at least two preset candidate battery detection schemes according to the noise intensity, the battery information, and the loaded capacity of the storage battery.

3. The method according to claim 1 or 2, **characterized in that** selecting one battery detection scheme from at least two preset candidate battery detection schemes according to the noise intensity and the battery information comprises
according to the noise intensity, determining at least one first candidate battery detection scheme from the preset at least two candidate battery detection schemes;
according to the battery information, determining at least one second candidate battery detection scheme from the preset at least two candidate battery detection schemes;
and selecting one battery detection scheme from the at least one first candidate battery detection scheme and the at least one second candidate battery detection scheme.

4. The method according to claim 3, **characterized in that** selecting one battery detection scheme from the at least one first candidate battery detection scheme and the at least one second candidate battery detection scheme comprises:
judging whether a same candidate battery detection scheme exists in the at least one first candidate battery detection scheme and the at least one second candidate detection scheme;
if so, determining one battery detection scheme from the same candidate battery detection scheme;
and if not, determining one battery detection scheme from the at least one second candidate battery detection scheme.

5. The method according to claim 1, **characterized in that** the battery information comprises a nominal capacity of the storage battery and a current capacity of the storage battery, the duty cycle and the detection time being related to the nominal capacity of the storage battery and the current capacity of the storage battery, respectively.

6. The method according to claim 1, **characterized in that** acquiring noise intensity of the storage battery comprises:
acquiring a voltage jump amplitude and a maximum noise voltage amplitude of the storage battery;
and determining the noise intensity of the storage battery according to the voltage jump amplitude and the maximum noise voltage amplitude.

7. The method according to claim 1, **characterized in that** the battery information comprises an open circuit voltage and/or a temperature, wherein detecting the storage battery according to the battery detection scheme comprises:
calculating an internal resistance of the storage battery according to the battery detection scheme;
determining a CCA value of the storage battery according to the internal resistance of the storage battery;
and detecting the health state of the storage battery according to at least one of the open circuit voltage and/or the temperature, the battery detection scheme, the internal resistance, and the CCA value.

8. An apparatus (30) for detecting a storage battery of a vehicle (20) to assess a health state of the storage battery, **characterized by** comprising:
an acquisition module (301) for acquiring noise intensity of a storage battery and battery information of the storage battery;
a selection module (302) for selecting one battery detection scheme from at least two preset candidate battery detection schemes according to the noise intensity and the battery information; wherein the battery detection scheme comprises at least one of a discharge load value, a detection frequency, a duty cycle, and a detection time, wherein the discharge load value and the detection frequency are respectively related to the noise intensity, and the duty cycle and the detection time are respectively related to the battery information;
and a first detection module (303) for detecting the storage battery according to the battery detection scheme.

9. The apparatus (30) according to claim 8, **characterized by** further comprising:
a second detection module (304) for detecting an open circuit voltage of the storage battery;
and a determination module (305) for determining a loaded capacity of the storage battery according to the open circuit voltage;
wherein the selection module (302) comprises:
a first selection unit (3021) for selecting one battery detection scheme from at least two preset candidate battery detection schemes according to the noise intensity, the battery information, and the loaded capacity of the storage battery.

10. A battery detection device (10), **characterized by** comprising:
at least one processor (101); and
a memory (102) communicatively connected to the at least one processor (101), the memory (102) storing an instruction executable by the at least one processor (101), wherein the instruction is executable by the at least one processor (101) to enable the at least one processor (101) to execute the method of any of claims 1-7.

## Patentansprüche

1. Verfahren zur Erkennung einer Speicherbatterie eines Fahrzeugs (20) zum Bewerten eines Gesundheitszustands der Speicherbatterie, das auf eine Batterieerkennungsvorrichtung (10) angewandt wird, **dadurch gekennzeichnet, dass** es umfasst:
Erfassen von einer Rauschintensität einer Speicherbatterie und von Batterieinformationen der Speicherbatterie;
Auswählen eines Batterieerkennungsschemas von mindestens zwei voreingestellten Kandidaten-Batterieerkennungsschemata gemäß der Rauschintensität und den Batterieinformationen; wobei das Batterieerkennungsschema mindestens eines von einem Entladelastwert, einer Erkennungsfrequenz, einer Einschaltdauer und einer Erkennungszeit umfasst, wobei der Entladelastwert und die Erkennungsfrequenz jeweils mit der Rauschintensität verbunden sind und die Einschaltdauer und die Erkennungszeit jeweils mit den Batterieinformationen verbunden sind;
und Erkennen der Speicherbatterie gemäß dem Batterieerkennungsschema.

2. Verfahren nach Anspruch 1, **dadurch gekennzeichnet, dass** es ferner umfasst:
Erkennen einer Leerlaufspannung der Speicherbatterie;
und Bestimmen einer geladenen Kapazität der Speicherbatterie gemäß der Leerlaufspannung;
wobei das Auswählen eines Batterieerkennungsschemas von mindestens zwei voreingestellten Kandidaten-Batterieerkennungsschemata gemäß der Rauschintensität und den Batterieinformationen umfasst
Auswählen eines Batterieerkennungsschemas von mindestens zwei voreingestellten Kandidaten-Batterieerkennungsschemata gemäß der Rauschintensität, den Batterieinformationen und der geladenen Kapazität der Speicherbatterie.

3. Verfahren nach Anspruch 1 oder 2, **dadurch gekennzeichnet, dass** das Auswählen eines Batterieerkennungsschemas von mindestens zwei voreingestellten Kandidaten-Batterieerkennungsschemata gemäß der Rauschintensität und den Batterieinformationen umfasst
Bestimmen mindestens eines ersten Kandidaten-Batterieerkennungsschemas von den voreingestellten mindestens zwei Kandidaten-Batterieerkennungsschemata gemäß der Rauschintensität;
Bestimmen mindestens eines zweiten Kandidaten-Batterieerkennungsschemas von den voreingestellten mindestens zwei Kandidaten-Batterieerkennungsschemata gemäß den Batterieinformationen;
und Auswählen eines Batterieerkennungsschemas von dem mindestens einen ersten Kandidaten-Batterieerkennungsschema und dem mindestens einen zweiten Kandidaten-Batterieerkennungsschema.

4. Verfahren nach Anspruch 3, **dadurch gekennzeichnet, dass** das Auswählen eines Batterieerkennungsschemas von dem mindestens einen ersten Kandidaten-Batterieerkennungsschema und dem mindestens einen zweiten Kandidaten-Batterieerkennungsschema umfasst:
Beurteilen, ob ein gleiches Kandidaten-Batterieerkennungsschema in dem mindestens einen ersten Kandidaten-Batterieerkennungsschema und dem mindestens einen zweiten Kandidaten-Batterieerkennungsschema vorhanden ist;
wenn dies der Fall ist, Bestimmen eines Batterieerkennungsschemas von dem gleichen Kandidaten-Batterieerkennungsschema;
und. wenn dies nicht der Fall ist, Bestimmen eines Batterieerkennungsschemas von dem mindestens einen zweiten Kandidaten-Batterieerkennungsschema.

5. Verfahren nach Anspruch 1, **dadurch gekennzeichnet, dass** die Batterieinformationen eine Nennkapazität der Speicherbatterie und eine gegenwärtige Kapazität der Speicherbatterie umfassen, wobei die Einschaltdauer und die Erkennungszeit mit der Nennkapazität der Speicherbatterie beziehungsweise der gegenwärtigen Kapazität der Speicherbatterie verbunden sind.

6. Verfahren nach Anspruch 1, **dadurch gekennzeichnet, dass** das Erfassen einer Rauschintensität der Speicherbatterie umfasst:
Erfassen einer Spannungssprungamplitude und einer maximalen Rauschspannungsamplitude der Speicherbatterie;
und Bestimmen der Rauschintensität der Speicherbatterie gemäß der Spannungssprungamplitude und der maximalen Rauschspannungsamplitude.

7. Verfahren nach Anspruch 1, **dadurch gekennzeichnet, dass** die Batterieinformationen eine Leerlaufspannung und/oder eine Temperatur umfassen, wobei das Erkennen der Speicherbatterie gemäß dem Batterieerkennungsschema umfasst:
Berechnen eines Innenwiderstands der Speicherbatterie gemäß dem Batterieerkennungsschema;
Bestimmen eines CCA-Werts der Speicherbatterie gemäß dem Innenwiderstand der Speicherbatterie;
und Erkennen des Gesundheitszustands der Speicherbatterie gemäß mindestens einem von der Leerlaufspannung und/oder der Temperatur, dem Batterieerkennungsschema, dem Innenwiderstand und dem CCA-Wert.

8. Vorrichtung (30) zum Erkennen einer Speicherbatterie eines Fahrzeugs (20) zum Bewerten eines Gesundheitszustands der Speicherbatterie, **dadurch gekennzeichnet, dass** sie umfasst:
ein Erfassungsmodul (301) zum Erfassen von einer Rauschintensität einer Speicherbatterie und von Batterieinformationen der Speicherbatterie;
ein Auswahlmodul (302) zum Auswählen eines Batterieerkennungsschemas von mindestens zwei voreingestellten Kandidaten-Batterieerkennungsschemata gemäß der Rauschintensität und den Batterieinformationen; wobei das Batterieerkennungsschema mindestens eines von einem Entladelastwert, einer Erkennungsfrequenz, einer Einschaltdauer und einer Erkennungszeit umfasst, wobei der Entladelastwert und die Erkennungsfrequenz jeweils mit der Rauschintensität verbunden sind und die Einschaltdauer und die Erkennungszeit jeweils mit den Batterieinformationen verbunden sind;
und ein erstes Erkennungsmodul (303) zum Erkennen der Speicherbatterie gemäß dem Batterieerkennungsschema.

9. Vorrichtung (30) nach Anspruch 8, **dadurch gekennzeichnet, dass** es ferner umfasst:
ein zweites Erkennungsmodul (304) zum Erkennen einer Leerlaufspannung der Speicherbatterie;
und ein Bestimmungsmodul (304) zum Bestimmen einer geladenen Kapazität der Speicherbatterie gemäß der Leerlaufspannung;
wobei das Auswahlmodul (302) umfasst:
eine erste Auswahleinheit (3021) zum Auswählen eines Batterieerkennungsschemas von mindestens zwei voreingestellten Kandidaten-Batterieerkennungsschemata gemäß der Rauschintensität, den Batterieinformationen und der geladenen Kapazität der Speicherbatterie.

10. Batterieerkennungsvorrichtung (10), **dadurch gekennzeichnet, dass** sie umfasst:
mindestens einen Prozessor (101); und
einen Speicher (102), der kommunikativ mit dem mindestens einen Prozessor (101) verbunden ist, wobei der Speicher (102) eine Anweisung speichert, die von dem mindestens einen Prozessor (101) ausführbar ist, wobei die Anweisung von dem mindestens einen Prozessor (101) ausführbar ist, um es dem mindestens einen Prozessor (101) zu ermöglichen, das Verfahren nach einem der Ansprüche 1 bis 7 auszuführen.

## Revendications

1. Procédé pour détecter une batterie rechargeable d'un véhicule (20) afin d'évaluer un état d'intégrité de la batterie rechargeable, appliqué à un dispositif de détection de batterie (10), **caractérisé en ce qu'**il comprend les étapes suivantes :
acquérir une intensité de bruit d'une batterie rechargeable et des informations de batterie de la batterie rechargeable ;
sélectionner un schéma de détection de batterie parmi au moins deux schémas de détection de batterie candidats prédéfinis selon l'intensité de bruit et les informations de batterie ; dans lequel le schéma de détection de batterie comprend au moins un parmi une valeur de charge de décharge, une fréquence de détection, un rapport cyclique et un temps de détection, dans lequel la valeur de charge de décharge et la fréquence de détection sont respectivement liées à l'intensité de bruit, et le rapport cyclique et le temps de détection sont respectivement liés aux informations de batterie ;
et détecter la batterie rechargeable selon le schéma de détection de batterie.

2. Procédé selon la revendication 1, **caractérisé en ce qu'**il comprend en outre les étapes suivantes :
détecter une tension de circuit ouvert de la batterie rechargeable ;
et déterminer une capacité chargée de la batterie rechargeable selon la tension de circuit ouvert ;
dans lequel, selon l'intensité de bruit et les informations de batterie, le fait de sélectionner un schéma de détection de batterie parmi au moins deux schémas de détection de batterie candidats prédéfinis comprend le fait de sélectionner un schéma de détection de batterie parmi au moins deux schémas de détection de batterie candidats prédéfinis selon l'intensité de bruit, les informations de batterie et la capacité chargée de la batterie rechargeable.

3. Procédé selon la revendication 1 ou 2, **caractérisé en ce que** le fait de sélectionner un schéma de détection de batterie parmi au moins deux schémas de détection de batterie candidats prédéfinis selon l'intensité de bruit et les informations de batterie comprend ce qui suit :
selon l'intensité de bruit, déterminer au moins un premier schéma de détection de batterie candidat parmi les au moins deux schémas de détection de batterie candidats prédéfinis ;
selon les informations de batterie, déterminer au moins un deuxième schéma de détection de batterie candidat parmi les au moins deux schémas de détection de batterie candidats prédéfinis ;
et sélectionner un schéma de détection de batterie parmi l'au moins un premier schéma de détection de batterie candidat et l'au moins un deuxième schéma de détection de batterie candidat.

4. Procédé selon la revendication 3, **caractérisé en ce que** le fait de sélectionner un schéma de détection de batterie parmi l'au moins un premier schéma de détection de batterie candidat et l'au moins un deuxième schéma de détection de batterie candidat comprend ce qui suit :
juger s'il existe un même schéma de détection de batterie candidat dans l'au moins un premier schéma de détection de batterie candidat et l'au moins un deuxième schéma de détection de batterie candidat ;
si c'est le cas, déterminer un schéma de détection de batterie à partir du même schéma de détection de batterie candidat ;
et sinon, déterminer un schéma de détection de batterie à partir de l'au moins un deuxième schéma de détection de batterie candidat.

5. Procédé selon la revendication 1, **caractérisé en ce que** les informations de batterie comprennent une capacité nominale de la batterie rechargeable et une capacité actuelle de la batterie rechargeable, le rapport cyclique et le temps de détection étant liés à la capacité nominale de la batterie rechargeable et à la capacité actuelle de la batterie rechargeable, respectivement.

6. Procédé selon la revendication 1, **caractérisé en ce que** le fait d'acquérir une intensité de bruit de la batterie rechargeable comprend ce qui suit :
acquérir une amplitude de saut de tension et une amplitude de tension de bruit maximale de la batterie rechargeable ;
et déterminer l'intensité de bruit de la batterie rechargeable selon l'amplitude de saut de tension et l'amplitude de tension de bruit maximale.

7. Procédé selon la revendication 1, **caractérisé en ce que** les informations de batterie comprennent une tension de circuit ouvert et/ou une température, dans lequel le fait de détecter la batterie rechargeable selon le schéma de détection de batterie comprend ce qui suit :
calculer une résistance interne de la batterie rechargeable selon le schéma de détection de batterie ;
déterminer une valeur CCA de la batterie rechargeable selon la résistance interne de la batterie rechargeable ;
et détecter l'état d'intégrité de la batterie rechargeable selon au moins un parmi la tension de circuit ouvert et/ou la température, le schéma de détection de batterie, la résistance interne et la valeur CCA.

8. Appareil (30) pour détecter une batterie rechargeable d'un véhicule (20) afin d'évaluer un état d'intégrité de la batterie rechargeable, **caractérisé en ce qu'**il comprend :
un module d'acquisition (301) pour acquérir une intensité de bruit d'une batterie rechargeable et des informations de batterie de la batterie rechargeable ;
un module de sélection (302) pour sélectionner un schéma de détection de batterie parmi au moins deux schémas de détection de batterie candidats prédéfinis selon l'intensité de bruit et les informations de batterie ; dans lequel le schéma de détection de batterie comprend au moins un parmi une valeur de charge de décharge, une fréquence de détection, un rapport cyclique et un temps de détection, dans lequel la valeur de charge de décharge et la fréquence de détection sont respectivement liées à l'intensité de bruit, et le rapport cyclique et le temps de détection sont respectivement liés aux informations de batterie ;
et un premier module de détection (303) pour détecter la batterie rechargeable selon le schéma de détection de batterie.

9. Appareil (30) selon la revendication 8, **caractérisé en ce qu'**il comprend en outre :
un deuxième module de détection (304) pour détecter une tension de circuit ouvert de la batterie rechargeable ;
et un module de détermination (305) pour déterminer une capacité chargée de la batterie rechargeable selon la tension de circuit ouvert ;
dans lequel le module de sélection (302) comprend :
une première unité de sélection (3021) pour sélectionner un schéma de détection de batterie parmi au moins deux schémas de détection de batterie candidats prédéfinis selon l'intensité de bruit, les informations de batterie et la capacité chargée de la batterie rechargeable.

10. Dispositif de détection de batterie (10), **caractérisé en ce qu'**il comprend :
au moins un processeur (101) ; et
une mémoire (102) connectée en communication à l'au moins un processeur (101), la mémoire (102) stockant une instruction exécutable par l'au moins un processeur (101), dans lequel l'instruction est exécutable par l'au moins un processeur (101) pour permettre à l'au moins un processeur (101) d'exécuter le procédé selon l'une des revendications 1 à 7.
